(19) Europäisches Patentamt
European Patent Office
Office européen des brevets

(11) **EP 4 779 322 A1**

(12) **EUROPEAN PATENT APPLICATION**

(43) Date of publication:
**22.07.2026 Bulletin 2026/30**

(21) Application number: **26152302.1**

(22) Date of filing: **16.01.2026**

(51) International Patent Classification (IPC):
***G01R 1/20*** *(2006.01)*

(52) Cooperative Patent Classification (CPC):
**G01R 1/203;** G01R 19/0092; G01R 33/0017

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.01.2025 CN 202520111543 U**

(71) Applicant: **SCHNEIDER ELECTRIC INDUSTRIES SAS**
**92500 Rueil-Malmaison (FR)**

(72) Inventors:
• **BAI, Heng**
**XI'AN, 710076 (CN)**

• **ZHAO, Haijun**
**SHANGHAI, 201203 (CN)**
• **LU, Feng**
**SHANGHAI, 201203 (CN)**
• **SHI, Ying**
**SHANGHAI, 201203 (CN)**
• **ZHANG, Fenglian**
**SHANGHAI, 201203 (CN)**
• **LIU, Xia**
**SHANGHAI, 201203 (CN)**
• **XU, Jungang**
**XI'AN, 710076 (CN)**

(74) Representative: **Lavoix**
**Bayerstraße 83**
**80335 München (DE)**

(54) **CURRENT SAMPLING APPARATUS AND DEVICE BASED ON TWO-WIRE CIRCUIT**

(57) Embodiments of the disclosure provides a current sampling apparatus based on a two-wire circuit and a device. The current sampling apparatus comprises a sampling circuit arranged between a high voltage side and a low voltage side of a line to which the current sampling apparatus is connected; a sampling resistor connected in series in the sampling circuit to form a sampling current under a potential difference between the high voltage side and the low voltage side; a compensation circuit arranged close to the sampling resistor and adapted to provide a compensation current to generate a compensation magnetic field during flow of the sampling current in the sampling circuit, and the compensation magnetic field being adapted to at least partially offset an induced magnetic field of the sampling circuit; and a pair of voltage sampling interfaces respectively arranged at the two ends of the sampling resistor.

## Description

## FIELD

Example embodiments of the present disclosure generally relate to the field of electrical equipment, and in particular, to a current sampling apparatus based on a two-wire circuit and a device.

## BACKGROUND

In the field of industrial control or power distribution, current sampling is usually performed through a precision resistor, however, regardless of the package type, the precision resistor inevitably has lead or parasitic inductance. These lead or parasitic inductances may affect the sampling accuracy of the precision resistor.

## SUMMARY

In a first aspect of the present disclosure, a current sampling apparatus based on a two-wire circuit is provided. The current sampling apparatus comprises a sampling circuit arranged between a high voltage side and a low voltage side of a line to which the current sampling apparatus is connected; a sampling resistor connected in series in the sampling circuit to form a sampling current under a potential difference between the high voltage side and the low voltage side; a compensation circuit arranged close to the sampling resistor and adapted to provide a compensation current to generate a compensation magnetic field during flow of the sampling current in the sampling circuit, the compensation magnetic field being adapted to at least partially offset an induced magnetic field of the sampling circuit; and a pair of voltage sampling interfaces respectively arranged at two ends of the sampling resistor and adapted to acquire voltage signals at the two ends of the sampling resistor.

In some embodiments, the compensation circuit is parallel to the sampling circuit, and the compensation current of the compensation circuit is equal in magnitude and opposite in direction to the sampling current of the sampling circuit.

In some embodiments, a spacing between the compensation circuit and the sampling circuit is less than or equal to a predetermined spacing.

In some embodiments, the compensation circuit is connected in series with the sampling circuit.

In some embodiments, the current sampling apparatus further includes a compensation resistor connected in series in the compensation circuit.

In some embodiments, the current sampling apparatus further includes a detection module coupled to the pair of voltage sampling interfaces to determine the sampling current of the sampling circuit based on the voltage signals of the pair of voltage sampling interfaces.

According to the current sampling apparatus provided by embodiments of the disclosure, the compensation circuit is arranged on one side of the sampling circuit, and the compensation current passes through the compensation circuit during a period when the sampling current passes through the sampling circuit. The compensation current is the same as a change of the sampling current, and the current direction is opposite. In this way, the compensation magnetic field generated in the compensation circuit may at least partially offset the induced magnetic field in the sampling circuit. Therefore, the influence of the inductance of the resistor on the sampled current accuracy can be reduced, and the accuracy of the sampled current is improved.

In a second aspect of the present disclosure, a current sampling device is provided. The current sampling device comprises a circuit board and the current sampling apparatus according to the first aspect of the present disclosure, at least partially arranged within the circuit board.

In some embodiments, the sampling circuit and the compensation circuit are arranged in series in a same layer of the circuit board.

In some embodiments, the circuit board is a multilayer circuit board, and the sampling circuit and the compensation circuit are respectively arranged in adjacent layers of the circuit board, and the sampling circuit and the compensation circuit are aligned in a stacking direction of the multilayer circuit board.

In some embodiments, one of the sampling circuit and the compensation circuit is arranged in the circuit board and the other is attached to a surface of the circuit board.

It should be understood that the content described in this content section is not intended to limit the key features or important features of embodiments of the present disclosure, nor is it intended to limit the scope of the present disclosure. Other features of the present disclosure will become readily understood from the following description.

## BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:

FIG. 1 illustrates a schematic circuit diagram of a current sampling apparatus according to some embodiments of the present disclosure;

FIG. 2 illustrates a schematic circuit diagram of a current sampling apparatus according to some embodiments of the present disclosure;

FIG. 3A illustrates a schematic diagram of a current sampling device according to some embodiments of the present disclosure;

FIG. 3B illustrates a schematic diagram of a current sampling device according to some other embodiments of the present disclosure;

FIG. 3C illustrates a cross-sectional view of a current sampling device according to some embodiments of the present disclosure; and

FIG. 3D illustrates a cross-sectional view of a current sampling device according to some other embodiments of the present disclosure.

## DETAILED DESCRIPTION

Embodiments of the present disclosure will be described in more detail below with reference to the accompanying drawings. While certain embodiments of the present disclosure are shown in the accompanying drawings, it should be understood that the present disclosure may be implemented in various forms, and should not be construed as limited to embodiments set forth herein, but rather, these embodiments are provided for a more thorough and complete understanding of the present disclosure. It should be understood that the drawings and embodiments of the present disclosure are for example purposes only and are not intended to limit the scope of the present disclosure.

It should be noted that the title of any section/subsection provided herein is not limiting. Various embodiments are described throughout and any type of embodiments may be included in any section/subsection. Furthermore, embodiments described in any section/subsection may be combined in any manner with the same section/subsection and/or any other embodiment described in different sections/subsections.

In the description of the embodiments of the present disclosure, the terms "including" and the like should be understood to include "including but not limited to". The term "based on" should be understood as "based at least in part on". The terms "one embodiment" or "the embodiment" should be understood as "at least one embodiment". The term "some embodiments" should be understood as "at least some embodiments". Other explicit and implicit definitions may also be included below. The terms "first," "second," and the like may refer to different or identical objects. Other explicit and implicit definitions may also be included below.

As mentioned briefly above, in a conventional solution for determining a sampling current of a line by using a precision resistor, the precision resistor is connected in series in the line to be measured, and voltage signals at two ends of the precision resistor are detected. The sampling current of the line is further determined according to the detected voltage signals and a resistance value of the precision resistor. However, in such a sampling method, an instantaneous voltage drop generated by lead inductance or parasitic inductance of the precision resistor can seriously affect the sampling accuracy under an operation condition of a high-frequency large current or a large current fluctuation (di/dt).

In order to reduce the influence of the inductance of the precision resistor on the sampling accuracy, conventional processing methods include: 1) compensating the sampling value by software, and 2) compensating the sampling voltage by using the resistor-capacitance lag characteristic.

However, the above processing methods also have certain defects. For example, for the method 1), the requirement for the software processing time and the compensation accuracy is high, and it is usually necessary to predict the current fluctuation (di/dt) range that the actual circuit may generate, and only perform compensation processing within a determined current fluctuation range. For the method 2), a fixed resistor-capacitance parameter can only compensate for a certain range of parasitic inductance, so the requirement for the consistency of the parasitic inductance of the precision resistor is high.

The present disclosure provides a current sampling apparatus based on a two-wire circuit and a device to solve or at least partially solve the above problems and other potential problems existing in the conventional solutions. According to a current sampling apparatus based on a two-wire circuit provided by some embodiments of the present disclosure, a compensation circuit is arranged on one side of the sampling circuit, and a compensation current passes through the compensation circuit during a period when the sampling current passes the sampling circuit. The compensation current is the same as a change of the sampling current, and the current direction is opposite. In this way, a compensation magnetic field generated in the compensation circuit may at least partially offset an induced magnetic field in the sampling circuit. Therefore, the influence of the inductance of the resistor on the sampled current accuracy can be reduced, and the accuracy of the sampled current is improved.

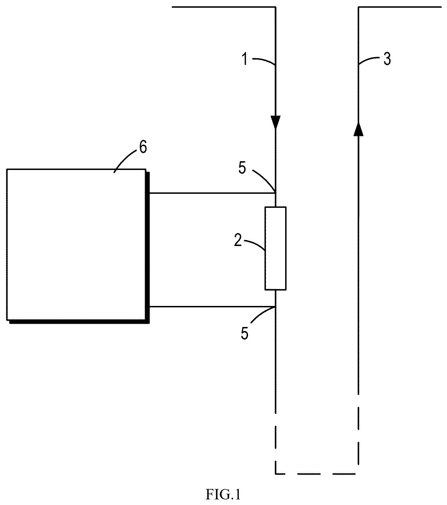

FIG. 1 shows a schematic circuit diagram of a current sampling apparatus according to some embodiments of the present disclosure. As shown in FIG. 1, the current sampling apparatus generally includes a sampling circuit 1, a sampling resistor 2 connected in series in the sampling circuit 1, a pair of voltage sampling interfaces 5 arranged at two ends of the sampling resistor 2, and a compensation circuit 3 arranged close to the sampling circuit 1.

The sampling circuit 1 is arranged between a high voltage side and a low voltage side of a line to which the current sampling apparatus is connected to form a sampling current on the sampling resistor 2 through a potential difference formed by the high voltage side and the low voltage side.

In some embodiments, the current sampling apparatus further includes a detection module 6. The detection module 6 is coupled to the pair of voltage sampling interfaces 5, acquires voltage signals at two ends of the sampling resistor 2 through the pair of voltage sampling interfaces 5, and determines the sampling current in the sampling circuit 1 based on at least the voltage signals and the characteristic parameter of the sampling resistor 2 (for example, a resistance value of the sampling resistor 2, etc. ).

In some embodiments, the compensation circuit 3 and the sampling circuit 1 are arranged in parallel with each other, and the sampling current in the sampling circuit 1 is equal in magnitude and opposite in direction to the compensation current in the compensation circuit 3. Thus, the induced magnetic field generated in the compensation circuit 3 may at least partially offset the induced magnetic field in the sampling circuit 1. Thus, an inductance generated by the sampling resistor 2 can be reduced by reducing a residual magnetic flux at the sampling resistor 2.

In an embodiment, a spacing between the compensation circuit 3 and the sampling circuit 1 is less than or equal to a predetermined spacing, specifically, according to an empirical formula: $L = 4 \times l(ln\frac{2a}{d} - \frac{a}{l}) \times 10^{-7}$ (where L is an inductance at the sampling resistor 2, a unit: H; 1 is a length of the sampling circuit 1 and/or the compensation circuit 3; d is a wire diameter of the sampling circuit 1 and/or the compensation circuit 3; a is a center distance between the sampling circuit 1 and the compensation circuit 3), it can be seen that the smaller the spacing between the compensation circuit 3 and the sampling circuit 1 is, the better the compensation circuit 3 offsets the induced magnetic field of the sampling circuit 1. Therefore, in some embodiments, where conditions permit, the compensation circuit 3 and the sampling circuit 1 may be disposed as close as possible, so that the compensation circuit 3 may better offset the induced magnetic field of the sampling circuit 1 at the sampling resistor 2.

In some embodiments, the compensation circuit 3 and the sampling circuit 1 may be connected in series. In this way, it can be ensured that the current in the compensation circuit 3 is equal to the current in the sampling circuit, and the synchronous fluctuation mode can be maintained. Thus, the current sampling apparatus can better cope with a high-frequency large current and a large current fluctuation (di/dt).

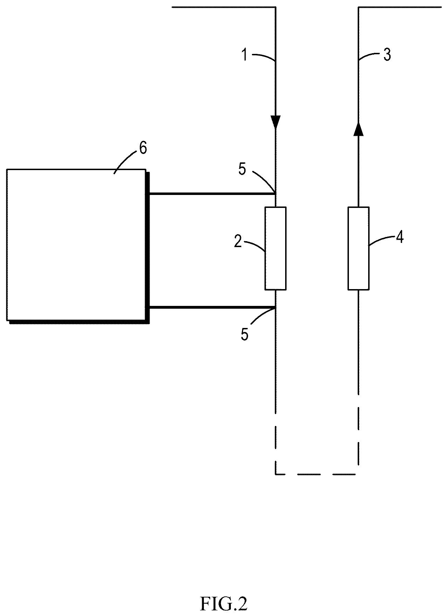

FIG. 2 shows a schematic circuit diagram of a current sampling apparatus according to some embodiments of the present disclosure. As shown in FIG. 2, in some embodiments, the current sampling apparatus further includes a compensation resistor 4, and the compensation resistor 4 is connected in series in the compensation circuit 3, and is adapted to generate an inductance opposite to the sampling resistor 2 during a current change of the sampling circuit 1 (i.e., during a current change of the compensation circuit 3), thereby further improving the accuracy of the sampled current detection.

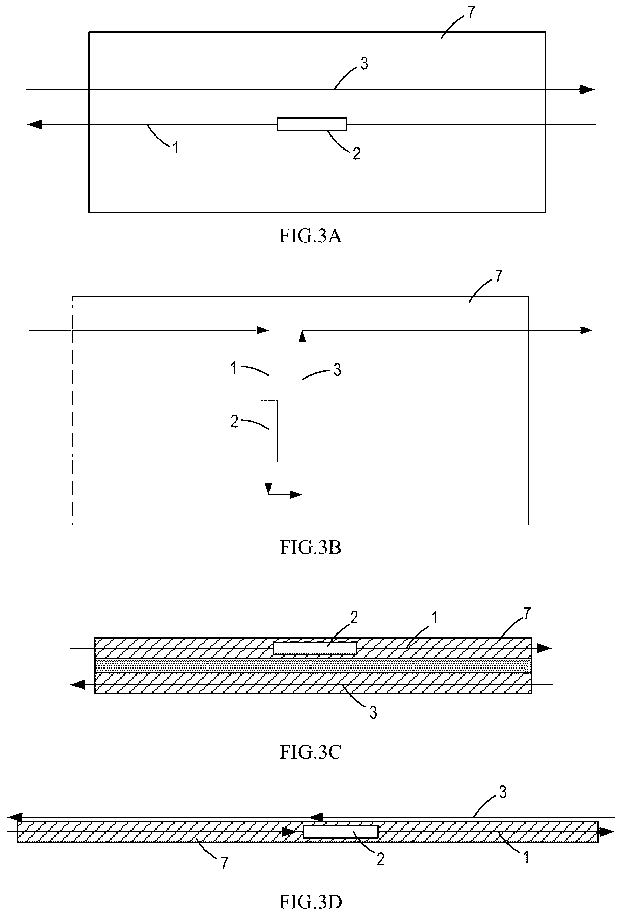

FIG. 3A illustrates a schematic diagram of a current sampling device according to some embodiments of the present disclosure. As shown in FIG. 3A, the current sampling device includes a circuit board 7 and a current sampling apparatus at least partially arranged in the circuit board 7. In some embodiments, a sampling circuit 1 and/or a compensation circuit 3 may be arranged within the circuit board 7 as a printed circuit layer, and the sampling circuit 1 and the compensation circuit 3 may be arranged in parallel with each other and with a predetermined interval therebetween. In some embodiments, the sampling circuit 1 and the compensation circuit 3 are arranged in series in a same layer of the circuit board 7.

FIG. 3B illustrates a schematic diagram of a current sampling device according to some other embodiments of the present disclosure. As shown in FIG. 3B, a line in a circuit board may be bent appropriately (for example, a line in a circuit board has a U-shaped bend), so that one part of the line serves as the sampling circuit 1, and the other part serves as the compensation circuit 3. In this way, the space utilization of the circuit board 7 can be optimized, and the space occupation of the line in the circuit board 7 can be reduced.

FIG. 3C illustrates a cross-sectional view of a current sampling device according to some embodiments of the present disclosure. As shown in FIG. 3C, in some embodiments, the circuit board 7 of the current sampling device may be a multilayer circuit board, the sampling circuit 1 and the compensation circuit 3 are respectively arranged in different printed circuit layers of the multilayer circuit board, and the sampling circuit 1 and the compensation circuit 3 are arranged in parallel in a stacking direction of the multilayer circuit board.

FIG. 3D shows a cross-sectional view of a current sampling device according to some other embodiments of the present disclosure, as shown in FIG. 3D, the sampling circuit 1 of the current sampling apparatus may be arranged in the circuit board 7, and the compensation circuit 3 may be attached to a surface of the circuit board 7 and remain parallel to the sampling circuit 1. Therefore, the sampling circuit 1 in the existing circuit board 7 can be optimized by an external circuit, so as to improve the sampling accuracy of the sampling circuit 1 in the circuit board 7. In some embodiments, the compensation circuit 3 of the current sampling apparatus may be arranged in the circuit board 7, and the sampling circuit 1 is attached to the circuit board 7.

Various implementations of the present disclosure have been described above, which are illustrative, not exhaustive, and are not limited to the implementations disclosed. Many modifications and variations will be apparent to those of ordinary skill in the art without departing from the scope and the various implementations illustrated. The selection of the terms used herein is intended to best explain the principles of the implementations, practical applications, or improvements to techniques in the marketplace, or to enable others of ordinary skill in the art to understand the various implementations disclosed herein.

## Claims

1. A current sampling apparatus based on a two-wire circuit, **characterized by** comprising:

   a sampling circuit (1) arranged between a high voltage side and a low voltage side of a line to which the current sampling apparatus is connected;
   a sampling resistor (2) connected in series in the sampling circuit (1) to form a sampling current under a potential difference between the high voltage side and the low voltage side;
   a compensation circuit (3) arranged close to the sampling resistor (2) and adapted to provide a compensation current to generate a compensation magnetic field during flow of the sampling current in the sampling circuit (1), the compensation magnetic field being adapted to at least partially offset an induced magnetic field of the sampling circuit (1); and
   a pair of voltage sampling interfaces (5) respectively arranged at two ends of the sampling resistor (2) and adapted to acquire voltage signals at two ends of the sampling resistor (2).

2. The current sampling apparatus of claim 1, **characterized in that** the compensation circuit (3) is parallel to the sampling circuit (1), and
   the compensation current of the compensation circuit (3) is equal in magnitude and opposite in direction to the sampling current of the sampling circuit (1).

3. The current sampling apparatus of claim 1 or 2, **characterized in that** a spacing between the compensation circuit (3) and the sampling circuit (1) is less than or equal to a predetermined spacing.

4. The current sampling apparatus of any one of claims 1-3, **characterized in that** the compensation circuit (3) is connected in series with the sampling circuit (1).

5. The current sampling apparatus of any one of claims 1-4, **characterized by** further comprising a compensation resistor (4) connected in series in the compensation circuit (3).

6. The current sampling apparatus of any one of claims 1-5, **characterized by** further comprising a detection module (6) coupled to the pair of voltage sampling interfaces (5) to determine the sampling current of the sampling circuit (1) based on the voltage signals of the pair of voltage sampling interfaces (5).

7. A current sampling device, **characterized by** comprising:

   a circuit board (7), and
   the current sampling apparatus of any one of claims 1-6, at least partially arranged within the circuit board (7).

8. The current sampling device of claim 7, **characterized in that** the sampling circuit (1) and the compensation circuit (3) are arranged in series in a same layer of the circuit board (7).

9. The current sampling device of claim 7 or 8, **characterized in that** the circuit board (7) is a multilayer circuit board, and
   the sampling circuit (1) and the compensation circuit (3) are respectively arranged in adjacent layers of the circuit board (7), and the sampling circuit (1) and the compensation circuit (3) are aligned in a stacking direction of the multilayer circuit board.

10. The current sampling device of any one of claims 7-9, **characterized in that** one of the sampling circuit (1) and the compensation circuit (3) is arranged in the circuit board (7), and the other is attached to a surface of the circuit board (7).

FIG.1

FIG.2

FIG.3A

FIG.3B

FIG.3C

FIG.3D

Europäisches
Patentamt

European
Patent Office

Office européen
des brevets

# EUROPEAN SEARCH REPORT

Application Number

**EP 26 15 2302**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/067148 A1 (TSUCHIDA KUNIO [JP] ET AL) 8 March 2018 (2018-03-08) * paragraph [0013] - paragraph [0014]; figures 1,2 * * paragraph [0030] - paragraph [0041] * * paragraph [0050] - paragraph [0056] * ----- | 1-10 | INV. G01R1/20 |
| A | US 2003/020592 A1 (HIRASAWA KOICHI [JP]) 30 January 2003 (2003-01-30) * paragraph [0081]; figure 16C * ----- | 1-10 | |
| A | US 2024/142499 A1 (MOBLEY JAMES [US] ET AL) 2 May 2024 (2024-05-02) * paragraph [0010] - paragraph [0014] * * paragraph [0027] - paragraph [0034] * ----- | 1-10 | |
| A | US 2019/324058 A1 (ENDO TAMOTSU [JP] ET AL) 24 October 2019 (2019-10-24) * paragraph [0008] - paragraph [0012] * * paragraph [0052] - paragraph [0057] * ----- | 1-10 | |
| | | | TECHNICAL FIELDS SEARCHED (IPC) G01R |

The present search report has been drawn up for all claims

| Place of search | Date of completion of the search | Examiner |
|---|---|---|
| Munich | 13 May 2026 | Molina, Vincent |

EPO FORM 1503 03.82 (P04C01)

## ANNEX TO THE EUROPEAN SEARCH REPORT
## ON EUROPEAN PATENT APPLICATION NO.

EP 26 15 2302

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2026

| Patent document cited in search report | | Publication date | Patent family member(s) | | Publication date |
|---|---|---|---|---|---|
| US 2018067148 | A1 | 08-03-2018 | CN | 107796981 A | 13-03-2018 |
| | | | DE | 102017120405 A1 | 08-03-2018 |
| | | | JP | 6487396 B2 | 20-03-2019 |
| | | | JP | 2018040632 A | 15-03-2018 |
| | | | US | 2018067148 A1 | 08-03-2018 |
| US 2003020592 | A1 | 30-01-2003 | US | 2003020592 A1 | 30-01-2003 |
| | | | US | 2005024806 A1 | 03-02-2005 |
| US 2024142499 | A1 | 02-05-2024 | NONE | | |
| US 2019324058 | A1 | 24-10-2019 | CN | 109416376 A | 01-03-2019 |
| | | | DE | 112017003516 T5 | 28-03-2019 |
| | | | JP | 6815772 B2 | 20-01-2021 |
| | | | JP | 2018009863 A | 18-01-2018 |
| | | | US | 2019324058 A1 | 24-10-2019 |
| | | | WO | 2018012150 A1 | 18-01-2018 |

EPO FORM P0459

For more details about this annex : see Official Journal of the European Patent Office, No. 12/82